# EUROPÄISCHE PATENTSCHRIFT

(11) **EP 0 835 498 B1**
(45) Veröffentlichungstag und Bekanntmachung des Hinweises auf die Patenterteilung: **01.09.1999**
(21) Anmeldenummer: 96918604.8
(22) Anmeldetag: 24.06.1996
(51) Int. Cl.: G06K 19/077

(54) **AN DATENBUS BETREIBBARER STAPELBARER DATENTRÄGER**
STACKABLE DATA CARRIER CAPABLE OF BEING OPERATED BY A DATA BUS
SUPPORT DE DONNEES EMPILABLE SUSCEPTIBLE D'ETRE EXPLOITE AVEC UN BUS DE DONNEES

(30) Priorität: 29.06.1995 DE 19523793
(43) Veröffentlichungstag der Anmeldung: 15.04.1998
(73) Patentinhaber: SIEMENS AKTIENGESELLSCHAFT, 80333 München (DE)
(72) Erfinder: SCHMIDT, Helge, D-67346 Speyer (DE); PREINER, Peter, D-81479 München (DE); EMBO, Georges, B-8920 Langemark (BE)
(86) Internationale Anmeldenummer: DE9601110
(87) Internationale Veröffentlichungsnummer: WO9701824

(56) Entgegenhaltungen:
- EP-A- 0 379 592
- EP-A- 0 546 680
- US-A- 5 176 523

## Beschreibung

Die Erfindung betrifft einen stapelbaren und tragbaren Datenträger, umfassend ein kartenförmiges Trägerelement, auf dem mindestens ein elektrisch programmierbarer, nicht-flüchtiger Halbleiterspeicher und mindestens ein mit dem Speicher elektrisch verbundener Außenanschluß des Datenträgers angeordnet ist, wobei der Außenanschluß Kontaktflachen aufweist, die derart an Oberflächen des Datentragers angeordnet sind, daß beim Aufeinanderlegen gleichartiger Datenträger ein elektrischer Kontakt zu den jeweils benachbarten Datenträgern und gleichzeitig zu einem Bussystem möglich ist.

Bisher sind insbesondere Datenträger mit standardisierten Abmessungen bekannt, die allgemein als Chipkarte bezeichnet werden und die in der Regel Halbleiterspeicherelemente mit relativ geringer Speicherkapazität und eine im Vordergrund stehende Logikschaltung enthalten. Mit der zunehmenden Verfügbarkeit kostengünstig herstellbarer Halbleiterspeicher, die eine Speicherkapazität mindestens im Megabit-Bereich aufweisen, entsteht der Wunsch, schnell und bequem auf eine Vielzahl gleichartiger Datentrager größtmöglicher Speicherkapazitat zugreifen zu können. Diese Datenträger sollen beispielsweise für digitalisierte Musiksignale, von einer elektronischen Kamera aufgenommene Bildsignale, Texte (wie beispielsweise gesamte Lexika), elektronische Landkarten, Software für Datenverarbeitungsanlagen, usw. bereitgestellt werden. Die Halbleiterspeicher können beschreibbare und löschbare Speicher oder nur Nur-Lese-Speicher (ROM) sein. Vorzugsweise sind die Daten in bezug auf ihre Redundanz komprimiert gespeichert.

In der nicht vorveröffentlichten deutschen Anmeldung Nr. P 44 35 122.4, die hiermit in die Offenbarung einbezogen wird, ist bereits ein stapelbarer Datenträger der eingangs genannten Art beschrieben, bei dem die Kontaktflachen vorzugsweise bündig um eine der Kantenflachen des Trägerelements umlaufend angeordnet sein sollen. Dadurch können mehrere solcher Karten probemlos übereinandergelegt werden, so daß gleichzeitig eine Vielzahl gleichartiger Datenträger ohne aufwendige zusätzliche Hilfsmittel an ein Verarbeitungsgerat angeschlossen werden kann. Bei bündig um eine Kante umlaufenden Anschlußflächen kommt eine unmittelbare gegenseitige Kontaktierung der übereinandergestapelten Karten ohne Kontaktschiene zustande. Erwähnt wird auch eine lose handhabbare Anschlußbuchse, die die gestapelten Datenträgerkarten in einem mechanisch festen Verbund hält.

Die direkt oder mittelbar miteinander verbundenen entsprechenden Anschlüsse mehrerer übereinander liegender Karten wirken in jedem Fall logisch als Datenbus, so daß alle Datenträger des Stapels simultan on-line angeschlossen sind, sobald nur einer der gestapelten Datenträger am Gerät angeschlossen ist.

In der obengenannten älteren Anmeldung werden im Zusammenhang mit der Möglichkeit, mehrere übereinanderliegende Datentragerkarten in einem Anschlußstück oder in einem Gehäuse zusammenzufassen, auch Positionierungsmittel vorgeschlagen, um die Chipkarten möglichst exakt übereinander anordnen zu können und damit an deren Anschlüssen ein exaktes Überlappen zu gewährleisten. Diese Positionierungsmittel umfasssen mindestens einen Vorsprung auf einer Hauptfläche des Trägerelements und eine entsprechende Vertiefung auf der gegenüberliegenden Haupt flache, in die der Vorsprung eines weiteren Datenträgers aufgenommen werden kann. Die dort offenbarten noppenartigen Vorsprünge sind jedoch, insbesondere aufgrund mangelnder Elastizität, nicht geeignet, eine dauerhafte Fixierung der gestapelten Datenträger auch bei äußerer Kraftanwendung zu gewährleisten. Darüberhinaus ist auch bei exaktem Überlappen der Anschlüsse noch keine ausreichende Kontaktkraft bzw. ein Toleranzausgleich in Stapelrichtung zwischen den verschiedenen Anschluß-Kontaktstellen gewährleistet.

Der vorliegenden Erfindung liegt die Aufgabe zugrunde, einen Datenträger der eingangs genannten Art anzugeben, der mit anderen gleichartigen Datenträgern dauerhaft und elektrisch funktionssicher aufeinander stapelbar ist und der auch unter Einwirkung einer mäßigen äußeren Kraftanwendung in einem eigenständigen Stapel mit einer festen Kontur fixiert bleibt.

Erfindungsgemäß wird diese Aufgabe bei einem Datenträger der eingangs genannten Art dadurch gelöst, daß die Kontur des Datenträgers so ausgebildet ist, daß die Konturen benachbarter gleichartiger Datenträger beim Aufeinanderlegen und die Datenträger zu einem mechanisch festen, aber lösbaren Verbund stapelbar sind, und daß gleichzeitig die jeweils benachbarten Datenträger des Verbunds über ihre jeweiligen Kontaktflächen miteinander in Kontakt kommen.

Weitere Ausgestaltungen der Erfindung sind Gegenstand der Unteransprüche.

Die Erfindung beruht im wesentlichen darauf, daß die Kontur der einzelnen Datenträger so ausgebildet ist, daß ein mechanisch stabiles, selbstarretierendes Ineinandergreifen einer Teilfläche mit einer entsprechend als Negativ ausgebildeten Komplementärfläche eines angrenzenden Datenträgers beispielsweise durch Auf- oder Einschnappen, durch Verschränken oder durch Ineinanderdrücken möglich ist, wobei neben dem Formschluß außerdem gleichzeitig mindestens an der galvanischen Kontaktstelle der unmittelbar aneinandergrenzenden Datenträger die für den elektrischen Kontakt erforderliche Kontaktkraft bewirkt sein muß. Letzteres kann insbesondere dadurch erreicht werden, daß die Kontaktflächen so ausgebildet und angeordnet sind, daß sie beim Zusammenfügen der Datenträger federnd zusammenwirken. Diese federnde Ausbildung der Kontaktflächen ist selbstverständlich auch bei anders als durch Verschnappen oder Verschränken von Teilflächen zu einem Verbund zusammenfügbaren und auch bei nur lose gestapelten Datenträgern zur Gewährleistung der Kontaktkraft selbständig anwendbar.

In einer Weiterbildung der Erfindung ist vorgesehen, daß die Kontaktflächen selbst so ausgebildet und angeordnet sind, daß sie beim Zusammenfügen der Datenträger gleichzeitig den Kontakt und mindestens einen Teil des mechanischen Kraftschlusses bewirken.

Die Erfindung wird nachfolgend anhand von mehreren Ausführungsbeispielen eines stapelbaren Datenträgers im Zusammenhang mit Figuren näher erläutert. Es zeigen:
Figur 1 eine perspektivische Aufsicht auf einen aus vier Datenträgern gebildeten Stapel,
Figur 2 in gleicher Darstellung einen anders ausgeführten, einzelnen Datenträger,
Figur 3 und 4 in geschnittener Seitenansicht, bzw. bei Figur 5, in seitlich geschnittener perspektivischer Aufsicht eine weitere Ausführungsform eines einzelnen, bzw. von vier zu einem Stapel zusammengefügten Datenträgern,
Figur 6 und 7 in geschnittener Seitenansicht, bzw. bei Figur 8, in seitlich geschnittener perspektivischer Aufsicht eine weitere Ausführungsform eines einzelnen, bzw. von vier zu einem Stapel zusammengefügten Datenträgern,
Figur 9 in perspektivischer Aufsicht und Figur 10 und 11 in geschnittener Seitenansicht weitere Ausführungsformen von bei stapelbaren Datenträgern einsetzbaren Kontaktausführungen.

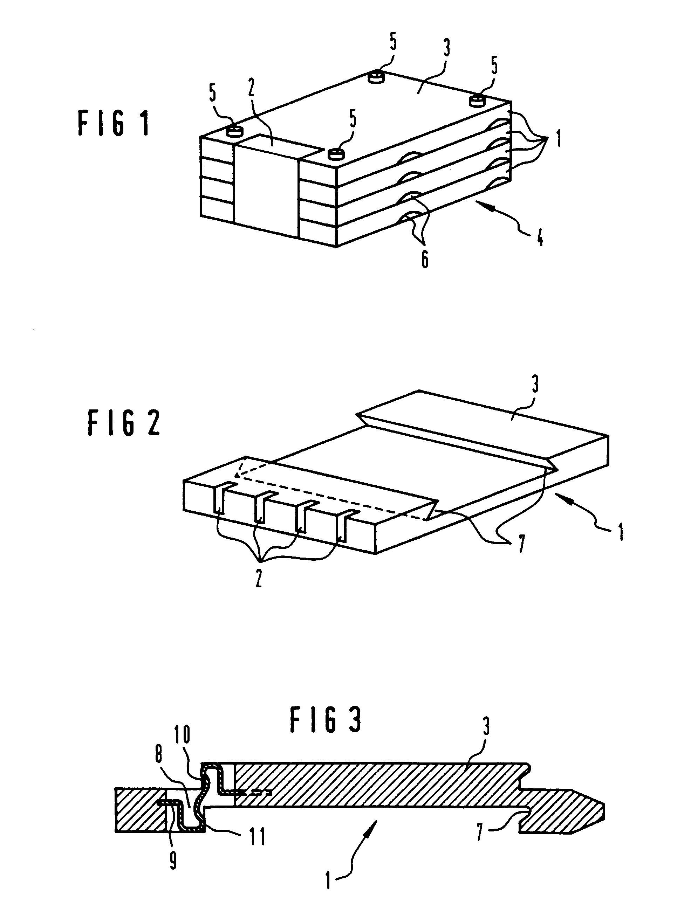

Die vier in Figur 1 dargestellten Datenträger 1 sind mittels ihrer jeweils um eine Querkante bündig umlaufenden Kontaktflächen 2 miteinander elektrisch verbunden. Die kartenförmigen Trägerelemente 3 bestehen jeweils vorzugsweise aus einem elektrisch isolierenden Kunststoffmaterial. Nicht dargestellt sind die verschiedenen integrierten Halbleiterschaltungen, die jeweils in Ausnehmungen des Trägerelements 3 aufgenommen oder vom Material des Trägerelements 3 völlig umgeben sind. Das mechanisch feste, jedoch lösbare Zusammenfügen der einzelnen Datenträger 1 zu einem Verbund 4 erfolgt bei der Ausführungsform gemäß Figur 1 nach dem Lego-Prinzip, wobei die dargestellten eindrückbaren Vorsprünge 5, die mit komplementären Vertiefungen auf den Unterseiten der Datenträger 1 zusammenwirken, jeweils eine ausreichende Eigenelastizität (Federwirkung) und Größe aufweisen müssen, um diese Funktion erfüllen zu können. Schematisch angedeutet sind auch die mindestens an einer Kantenfläche des Datenträgers 1 eingearbeiteten Mulden 6, die ein Vereinzeln der vier Datenträger 1 des Verbunds 4 ermöglichen.

Die Fixierung bzw. Aneinanderreihung der einzelnen Datenträger kann vorteilhaft so verwirklicht werden, daß der mechanische Kraftschluß mindestens teilweise durch auf mindestens einer der Hauptflächen des Datenträgers angeordnete Schwalbenschwanz-Führungen 7, wie in Figur 2 angedeutet, bewirkt ist. Die einzelnen Datenträger werden, wie bei Schwalbenschwanz-Führungen üblich, ineinandergeschoben oder, wenn der Schwalbenschwanz geringe Tiefe hat, kann auch durch Biegen ein Einschnappen erreicht werden. Generell kann der Schwalbenschwanz bei dieser und bei anderen Ausführungsformen auch in Längsrichtung der Datenträgerkarte ausgeführt sein. Bei einer anderen, nicht dargestellten Ausführungsform ist an einem Ende des Datenträgers auf beiden Hauptflächen eine Schwalbenschwanz-Führung in Querrichtung vorgesehen, während am anderen Ende,an den Ecken, beispielsweise quadratische Vorsprünge und, gegenüberliegend, Vertiefungen angeordnet sind. Das Zusammenfügen erfolgt, indem zunächst die komplementären Schwalbenschwanz-Führungen zweier Datenträger locker in Eingriff gebracht und anschließend durch Ineinanderdrücken der beiden Datenträger am anderen Ende die Datenträger zum Verschnappen gebracht werden. Durch Auseinanderziehen an den letztgenannten Enden können die Datenträger wieder aufgeschnappt und vereinzelt werden

In den Figuren 3 bis 5 ist eine Ausführungsform dargestellt, bei der zwei benachbarte Datenträger 1 an einem Ende beispielsweise mittels einer konventionellen Schwalbenschwanz-Führung 7 quer zur Längsrichtung ineinandergreifen, während am gegenüberliegenden Ende in einer Öffnung 8 des Trägerelements 3 eine S-förmige Kontaktfeder 9 vorgesehen ist, deren oberer Teil 10 mit dem unteren Teil 11 einer darüber angeordneten Kontaktfeder 12 eines benachbarten Datenträgers 1 nach dem Schwalbenschwanz-Prinzip zusammenwirken kann. Das elastische Zusammenwirken der Kontaktfedern 9, 12 gewährleistet also den Kraftschluß und eine feste Verbindung dieser Enden der Datenträger 1, so daß dort gleichzeitig eine hohe Kontaktkraft gegeben ist.

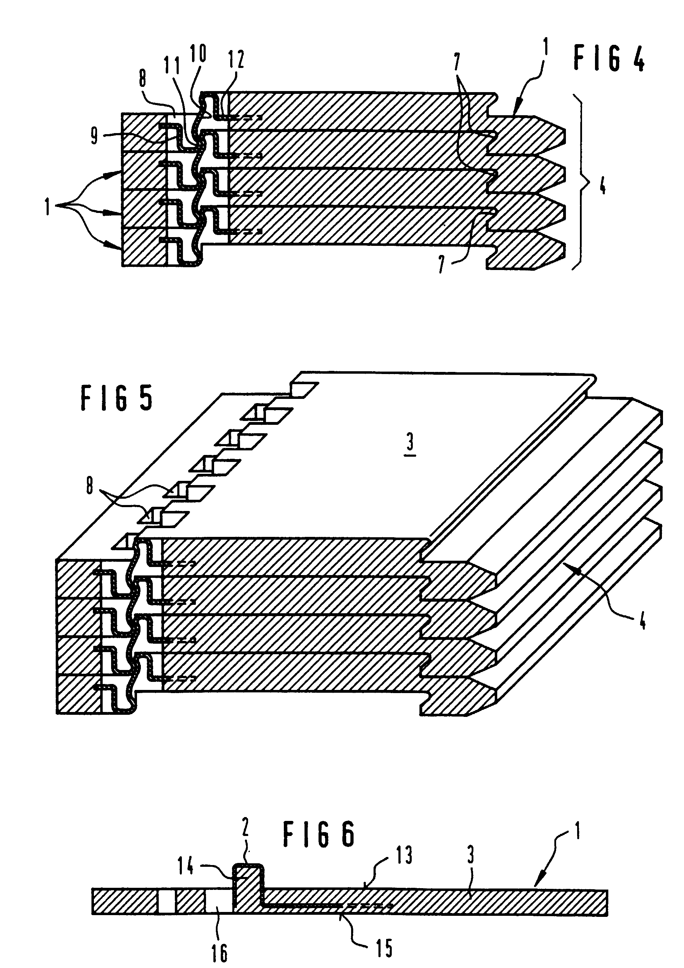

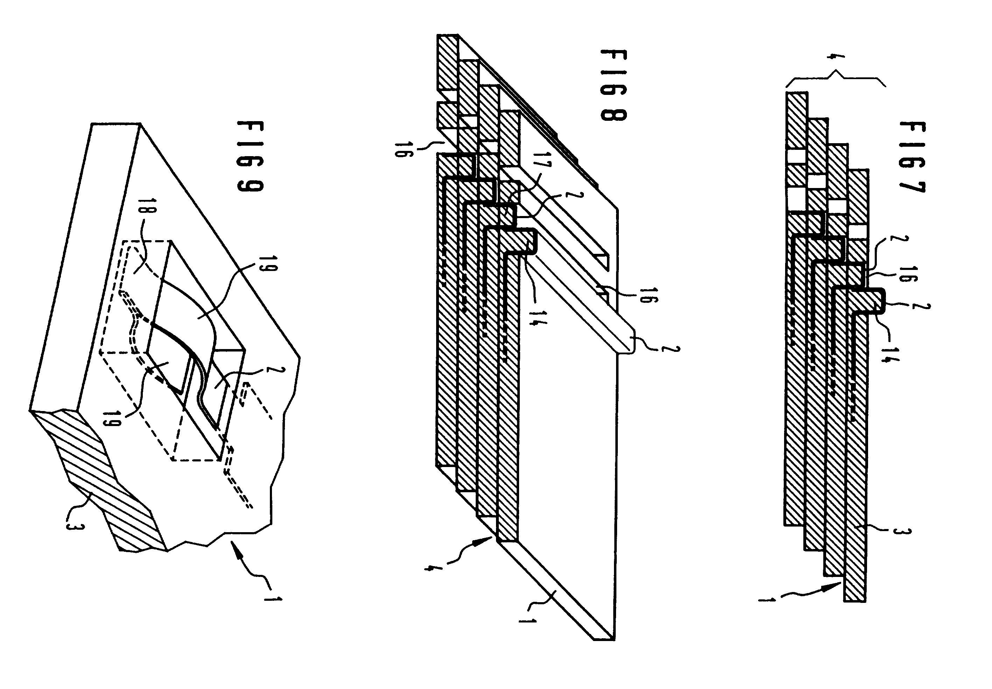

In den Figuren 6 bis 8 ist eine treppenartig stapelbare Ausführungsform dargestellt, bei der die Kontaktflächen 2 mindestens auf einem Teil der Oberfläche mindestens eines auf einer Hauptfläche 13 angeordneten Vorsprunges 14 und gleichzeitig mindestens auf einem Teil der Oberfläche einer unmittelbar neben dem Vorsprung 14 auf der gegenüberliegenden Hauptfläche 15 angeordneten entsprechenden Vertiefung 16, in die der Vorsprung 17 eines weiteren Datenträgers 1 aufgenommen werden kann, aufliegen. Ein federndes Zusammenwirken der Kontaktflächen ist hier insofern gegeben, als die teilweise mit Kontaktflachen 2 belegten Vorsprünge 14 bzw. Vertiefungen 16 beim Aufschnappen zu einem Treppenstapel auf Toleranz ausweichen können und müssen. Treppenstapel-Anordnungen haben den generellen Vorteil, daß sie die Vereinzelung und die äußere Visualisierung der Anzahl der gestapelten Datenträger durch den Kunden erleichtern.

Insbesondere aus dem Ausführungsbeispiel gemäß Figuren 6 bis 8 ist ersichtlich, daß die Erfindung nicht auf deckungsgleich übereinander gestapelte Datenträger beschränkt ist. Auch die Kontaktflachen müssen nicht deckungsgleich in Stapelrichtung übereinanderliegen. Im übrigen können Dummykarten oder Busverstärkerkarten oder sonstige Kopplungskarten mit entsprechender Außenkontur in den Stapel eingefügt werden. Ein solcher Verbund ist dann aus einer Vielzahl von in mindestens zwei Gruppen aufgeteilten Datenträgern gebildet, wobei die Gruppen beispielsweise durch eine eingefügte Busverstärkerkarte mechanisch und elektrisch verbunden sind. Die gleichartigen Datenträger können auch durch aus größeren Datenträgern einschließlich Außenanschlüsse herausbrechbaren Untereinheiten gebildet sein.

Üblicherweise enthält ein Datenträger gemäß der Erfindung einen oder mehrere in einer Ebene auf einem flachen Leadframe angeordnete Halbleiterschaltkreise. Möglich ist jedoch ebenso eine Anordnung in zwei oder mehr Ebenen, wobei die Höhe der Datenträger entsprechend gewählt werden kann, so daß der einzelne Datenträger stark quader- oder gar annähernd würfelförmige Gestalt aufweist. Dabei müssen nicht die Kontakte jeder einzelnen Ebene herausgeführt werden, sondern die Außenanschlüsse können gesammelt einmalig für die Kontaktierung zur Verfügung gestellt werden. Auch derartige, vom äußeren Erscheinungsbild der bekannten Chipkarten stark abweichende Datenträger können erfindungsgemäß gestapelt und untereinander unmittelbar kontaktiert werden.

Der generelle Vorteil aller Ausführungen besteht darin, daß kein Gerätestecker mehr nötig ist. Die Halbleiterschaltkreise können allgemein auf einem Leadframe, einer Leiterplatte oder auf einer in MID (Molded Interconnect Devices)-Technik hergestellten dreidimensionalen Leiterplatte angeordnet sein. Bei letzteren wird das Sschaltungslayout dadurch erzeugt, daß ein aus verschiedenen Kunststoffen erzeugter Verbundkörper eine selektiv metallisierbare Oberfläche erhält.

In Fig. 9 ist eine federnde Kontaktausführung dargestellt, bei der die Kontaktflächen 2 zurückversetzt und teilweise versenkt in einer Ausnehmung im Trägerelement 3 des Datenträgers angeordnet sind. Die Kontaktflachen können, wie angedeutet, einstückig aus dem Leadframe herausgeformt sein und beispielsweise, wie dargestellt, einen Biegebereich 18 und jeweils in Stapelrichtung orientierte, knapp über die Hauptflächen vorstehende Kuppelbereiche 19 aufweisen. Der Biegebereich 18 kann frei in der Ausnehmung angeordnet oder im Trägerelement 3 eingespritzt sein. Beim Stapeln von Datenträgern drücken sich die verschiedenen Datenträgern zugehörigen Kuppelbereiche 19 gegenseitig aufgrund ihrer Elastizität in die Ausnehmungen hinein.

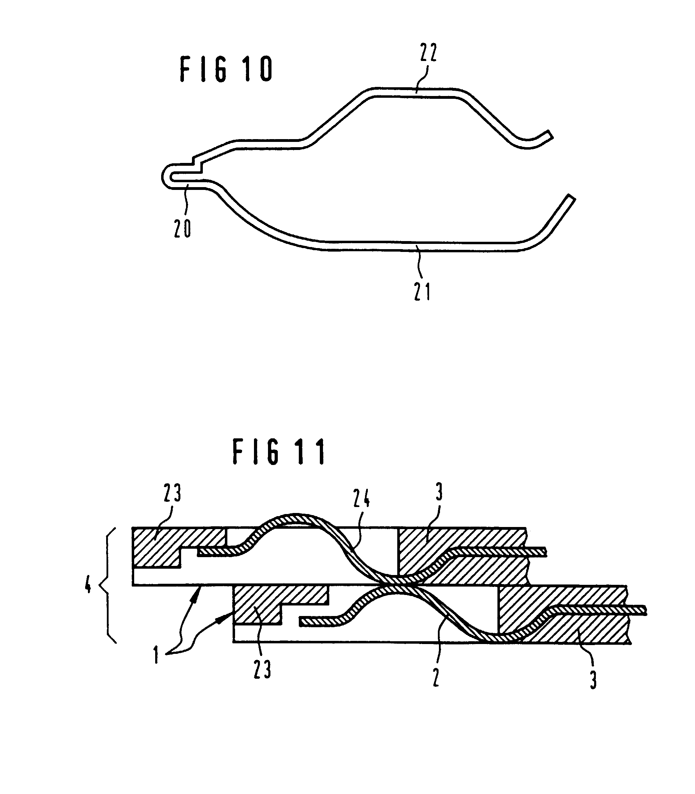

In Fig. 10 ist eine Kontaktausführung dargestellt, bei der ein umgeklappter Blechstreifen 20 zu den beiden Hauptflächen des nicht dargestellten Datenträgers hin unsymmetrisch ausgeformt wurde. Während der Blechstreifen 20 nach unten starr mit wannenartiger Form 21 ausgeprägt wurde, wird im oberen Teil eine dachartige Federzunge 22 erzeugt. Dieses Gebilde kann der Länge nach in einer zum Datenträgerrand hin offenen, länglichen Aussparung versenkt werden. Im Stapel drückt die ein Kontaktmesser bildende Wannenform 21 auf die Federzunge 22 eines Folgekontakts. Wenn die Wannenform 21 mittig konzentriert und weniger breit als dargestellt ausgeführt ist, können im oberen Teil auch zwei zur Mitte hin geöffnete Federzungen 22 vorgesehen sein, zwischen die die Wannenform 21 eines Folgekontakts federnd hineindrückt. Durch die gegenseitige Justage ergibt sich ein selbstverrastender Kontakt, der an einer Datenträgerseite oder innerhalb angeordnet sein kann. Die Varianten gemäß Fig. 10 und 11 können beispielsweise beim Stapeln nach dem Lego-Prinzip eingesetzt werden.

In Fig. 11 sind für eine Treppenstapelanordnung geeignete, in Stapelrichtung elastische Kontaktflächen 2, 24, die in Ausnehmungen im Datenträger 1 angeordnet sind, dargestellt. Die untere, quer zur Stapelrichtung s-förmige Kontaktfläche 2 liegt, anders als die zum darübergestapelten Datenträger 1 gehörige obere Kontaktfläche 24, nicht am Anschlag 23 an, da sie vom darübergestapelten Datenträger 1 hinuntergedrückt wird.

Bei allen Ausführungen besteht die Möglichkeit, den Verbund mindestens zu einer Stapelseite hin durch eine Verpackung abzuschließen, deren stapelseitige Kontur der angrenzenden Kontur des Datenträgers entspricht. Die Kontur des angrenzenden Datenträgers dient hier also als Aufnahme für ein passend geformtes Verpackungselement, das beispielsweise auch V-förmig um den Stapel herumklappbar und auf beiden Stapelseiten verschränkbar ausgeführt sein kann.

## Patentansprüche

1. Stapelbarer und tragbarer Datenträger, umfassend ein kartenförmiges Trägerelement (3), auf dem mindestens ein elektrisch programmierbarer, nicht-flüchtiger Halbleiterspeicher und mindestens ein mit dem Speicher elektrisch verbundener Außenanschluß des Datenträgers (1) angeordnet ist, wobei der Außenanschluß Kontaktflächen (2) aufweist, die derart an Oberflächen des Datenträgers (1) angeordnet sind, daß beim Aufeinanderlegen gleichartiger Datenträger (1) ein elektrischer Kontakt zu den jeweils benachbarten Datenträgern (1) und gleichzeitig zu einem Bussystem möglich ist, wobei die Kontur des Datenträgers (1) so ausgebildet ist, daß die Konturen benachbarter gleichartiger Datenträger (1) beim Aufeinanderlegen formschlüssig verbindbar und die Datenträger (1) zu einem mechanisch festen, aber lösbaren Verbund (4) stapelbar sind, und daß gleichzeitig die jeweils benachbarten Datenträger (1) des Verbunds (4) über ihre jeweiligen Kontaktflächen (2) miteinander in Kontakt kommen.

2. Datenträger nach Anspruch 1, wobei die Kontur zu den beiden Hauptflächen (13, 15) des Datenträgers (1) hin komplementär ausgebildet ist, und daß zueinander komplementäre Seiten benachbarter Datenträger (1) miteinander verschnappbar sind.

3. Datenträger nach Anspruch 1 oder 2, wobei die Kontaktflächen (2) so ausgebildet und angeordnet sind, daß sie beim Zusammenfügen der Datenträger (1) federnd zusammenwirken.

4. Datenträger nach einem der Ansprüche 1 bis 3, wobei die Kontaktflächen (2) selbst so ausgebildet und angeordnet sind, daß sie beim Zusammenfügen der Datenträger (1) gleichzeitig den Kontakt und mindestens einen Teil des mechanischen Kraftschlusses bewirken.

5. Datenträger nach einem der Ansprüche 1 bis 4, wobei der mechanische Kraftschluß durch auf mindestens einer der Hauptflächen (13, 15) des Datenträgers (1) angeordnete Schwalbenschwanz-Führungen (7) bewirkt ist.

6. Datenträger nach Anspruch 4, wobei die Kontaktflächen (2) mindestens auf einem Teil der Oberfläche mindestens eines auf einer Hauptfläche (13) angeordneten Vorsprunges (14) und gleichzeitig mindestens auf einem Teil der Oberfläche einer unmittelbar neben dem Vorsprung (14) auf der gegenüberliegenden Hauptfläche (15) angeordneten entsprechenden Vertiefung (16), in die der Vorsprung (17) eines weiteren Datenträgers (1) aufgenommen werden kann, aufliegen.

7. Datenträger nach einem der Ansprüche 1 bis 6, wobei an mindestens einer Kantenfläche des Datenträgers (1) Mulden (6) eingearbeitet sind, die ein Vereinzeln der Datenträger (1) des Verbunds (4) ermöglichen.

8. Datenträger nach einem der Ansprüche 1 bis 7, wobei mindestens zwei Halbleiterschaltkreise in mindestens zwei Ebenen übereinander im Datenträger (1) angeordnet sind und daß die Außenanschlüsse der Halbleiterschaltkreise gesammelt aus dem Datenträger (1) herausgeführt sind.

9. Anordnung aus mindestens zwei Datenträgern nach einem der Ansprüche 1 bis 8, wobei der Verbund (4) aus einer Vielzahl von Datenträgern gebildet ist, daß die Vielzahl in mindestens zwei Gruppen aufgeteilt ist und daß die miteinander verbundenen Kontaktflächen (2) einer der Gruppen mit den miteinander verbundenen Kontaktflächen (2) einer anderen der Gruppen über die Kontaktflächen (2) einer mit den benachbarten Gruppen verschränkten Kopplungskarte verbunden sind, wobei die Kontur der Kopplungskarte der Kontur der Datenträger entspricht.

10. Anordnung aus mindestens zwei Datenträgern nach einem der Ansprüche 1 bis 9, wobei der Verbund mindestens zu einer Stapelseite hin durch eine Verpackung abgeschlossen ist, deren stapelseitige Kontur der angrenzenden Kontur des Datenträgers (1) entspricht.

## Claims

1. Stackable and portable data carrier, comprising a carrier element (3) which is in the form of a card and on which at least one electrically programmable non-volatile semiconductor memory and at least one external terminal of the data carrier (1) which is electrically connected to the memory are arranged, the external terminal having contact surfaces (2) which are arranged on surfaces of the data carrier (1) in such a way that, when data carriers (1) of the same type are placed one on top of the other, it is possible to have electrical contact with the respectively neighbouring data carriers (1) and at the same time with a bus system, the contour of the data carrier (1) being designed in such a way that the contours of neighbouring data carriers (1) of the same type can interlock when they are placed one on top of the other and the data carriers (1) can be stacked to form a mechanically rigid but detachable assembly (4), and at the same time the respectively neighbouring data carriers (1) of the assembly (4) come into contact with one another via their respective contact surfaces (2).

2. Data carrier according to Claim 1, the contour being designed as complementary in the direction of the two main faces (13, 15) of the data carrier (1), and mutually complementary sides of neighbouring data carriers (1) can be snap-fitted to one another.

3. Data carrier according to Claim 1 or 2, the contact surfaces (2) being designed and arranged in such a way that they interact resiliently when the data carriers (1) are brought together.

4. Data carrier according to one of Claims 1 to 3, the contact areas (2) themselves being designed and arranged in such a way that, when the data carriers (1) are brought together, they simultaneously bring about the contact and at least part of the mechanical interlocking.

5. Data carrier according to one of Claims 1 to 4, the mechanical interlocking being brought about by dovetail guides (7) arranged on at least one of the main faces (13, 15) of the data carrier (1).

6. Data carrier according to Claim 4, the contact surfaces (2) lying on at least a part of the surface of at least one projection (14) arranged on a main face (13) and, at the same time, at least on a part of the surface of a corresponding indentation (16) arranged directly next to the projection (14) on the opposite main face (15) and in which the projection (17) of another data carrier (1) can be accommodated.

7. Data carrier according to one of Claims 1 to 6, recesses (6) which make it possible to separate the data carriers (1) from the assembly (4) being formed on at least one edge face of the data carrier (1).

8. Data carrier according to one of Claims 1 to 7, at least two semiconductor circuits being arranged in at least two planes above one another in the data carrier (1), the external terminals of the semiconductor circuits are routed out in combination from the data carrier (1).

9. Arrangement made up of at least two data carriers according to one of Claims 1 to 8, the assembly (4) being formed by a plurality of data carriers, the plurality is divided into at least two groups, and the mutually connected contact surfaces (2) of one of the groups are coupled to the mutually connected contact surfaces (2) of another of the groups via the contact surfaces (2) of a coupling card interconnected to the neighbouring groups, the contour of the coupling card corresponding to the contour of the data carriers.

10. Arrangement made up of at least two data carriers according to one of Claims 1 to 9, the assembly being closed off in the direction of at least one stack side by a casing whose stack-side contour corresponds to the adjoining contour of the data carrier (1).

## Revendications

1. Support de données empilable et transportable, comprenant un élément support (3) en forme de carte sur lequel sont disposées au moins une mémoire à semi-conducteur non volatile électriquement programmable et au moins une connexion extérieure du support de données (1) connectée électriquement à la mémoire, la connexion extérieure présentant des surfaces de contact (2) qui sont disposées sur des surfaces du support de données (1) de telle manière que, lorsque des supports de données (1) de même genre sont superposés, il soit possible de réaliser un contact électrique avec les supports de données (1) respectivement adjacents et en même temps avec un système de bus, dans lequel le contour du support de données (1) est configuré de manière que les contours de plusieurs supports de données (1) adjacents du même genre, puissent être assemblés par engagement positif lors de la superposition et que les supports de données (1) puissent être empilés en un bloc (4) mécaniquement solide mais cependant démontable et en ce que les supports de données (1) mutuellement adjacents du bloc (4) entrent simultanément en contact entre eux par leurs surfaces de contact (2) respectives.

2. Support de données selon la revendication 1, dans lequel le profil des deux grandes faces (13, 15) des supports de données (1) est de configuration complémentaire, et des côtés mutuellement complémentaires des supports de données (1) adjacents peuvent être encliquetés l'un dans l'autre.

3. Support de données selon la revendication 1 ou 2, dans lequel les surfaces de contact (2) sont constituées et agencées de manière à coopérer élastiquement lors de l'assemblage des supports de données (1).

4. Support de données selon l'une des revendications 1 à 3, dans lequel les surfaces de contact (2) elles-mêmes sont configurées et disposées de manière que, lors de l'assemblage des supports de données (1), elles assurent simultanément le contact et au moins une partie de l'adhérence mécanique.

5. Support de données selon les revendications 1 à 4, dans lequel l'adhérence mécanique est déterminée par des guidages à queue d'aronde (7) agencés sur au moins une des grandes faces (13, 15) du support de données (1).

6. Support de données selon la revendication 4, dans lequel les surfaces de contact (2) s'appuient au moins sur une partie de la surface d'au moins une saillie (14) disposée sur une grande face (13), et, en même temps, au moins sur une partie de la surface d'un alvéole (16) correspondant, prévu directement à côté de la saillie (14) sur la grande face opposée (15), et dans lequel la saillie (17) d'un autre support de données (1) peut se loger.

7. Support de données selon l'une des revendications 1 à 6, dans lequel, sur au moins une rive du support de données (1), sont formées des encoches (6) qui permettent de séparer les supports de données (1) du bloc (4).

8. Support de données selon l'une des revendications 1 à 7, dans lequel au moins deux circuits à semi-conducteur sont disposés dans au moins deux plans l'un au-dessus de l'autre dans le support de données (1) et les connexions extérieures des circuits à semi-conducteurs émergent ensemble du support de données (1).

9. Dispositif composé d'au moins deux supports de données selon l'une des revendications 1 à 8, dans lequel le bloc (4) est composé d'une pluralité de supports de données, la pluralité est divisée en au moins deux groupes et les surfaces de contact (2) d'un des groupes, qui sont reliées entre elles, sont connectées au surfaces de contact (2) reliées entre elles, d'un autre des groupes, par les surfaces de contact (2) d'une carte de couplage emboîtée avec les groupes adjacents, le contour de la carte de couplage correspondant au contour des supports de données.

10. Dispositif composé d'au moins deux supports de données selon l'une des revendications 1 à 9, dans lequel le bloc est terminé, au moins sur un côté de l'empilement, par un emballage dont le profil côté empilement correspond au profil adjacent du support de données (1).
